# EUROPÄISCHE PATENTSCHRIFT

(11) **EP 0 496 978 B1**
(45) Veröffentlichungstag und Bekanntmachung des Hinweises auf die Patenterteilung: **11.09.1996**
(21) Anmeldenummer: 91120538.3
(22) Anmeldetag: 29.11.1991
(51) Int. Cl.: B22D 27/04, C30B 11/14, C30B 11/00

(54) **Verfahren und Vorrichtung zur Herstellung von einkristallinen Triebwerksschaufeln**
Process and apparatus for producing single crystal motor blades
Procédé et dispositif pour la fabrication d'aubes de moteur monocristallines

(30) Priorität: 13.12.1990 DE 4039808
(43) Veröffentlichungstag der Anmeldung: 05.08.1992
(73) Patentinhaber: SULZER- MTU CASTING TECHNOLOGY GmbH, D-80995 München (DE)
(72) Erfinder: Wortmann, Jürgen, Dr., W-8061 Weichs (DE); Wege, Robert, W-8000 München 50 (DE); Staub, Fritz, CH-8472 Seuzach (CH); Walser, Bruno, CH-8352 Schottikon (CH)
(74) Vertreter: Baum, Wolfgang, Dipl.-Ing.

(56) Entgegenhaltungen:
- DE-A- 2 307 463
- FR-A- 2 444 091
- FR-A- 2 444 092
- US-A- 4 412 577
- AVIATION WEEK AND SPACE TECHNOLOGY Bd. 111, Nr. 23, 3. Dezember 1979, NEW YORK, USA, Seiten 41-53
- MAYFIELD: 'Computer-Controlled Production Gains'
- SULZER TECHNICAL REVIEW Bd. 70, Nr. 3, 1988, WINTERTHUR, CH Seiten 1-16; STAUB ET AL.: 'An Alternative Process for the Manufacture of Single Cristal Gas Turbine Blades'
- PATENT ABSTRACTS OF JAPAN vol. 8, no. 7 (C-204)(1444) 12Januar1984 & JP-A-58 176 194 (NIPPON DENSHIN DENWA KOSHA), 15 Oktober 1983

## Beschreibung

Die Erfindung betrifft ein Verfahren zur Herstellung von einkristallinen Triebwerksschaufeln durch Vergießen einer Metallschmelze in eine Gießform mit am Boden der Gießform angeordnetem Keimkristall.

Aus der US-PS 3,857,436 ist ein Verfahren und eine Vorrichtung bekannt, die eine Herstellung von einkristallinen Bauteilen mittels eines einkristallinen Keimkristalls am Boden einer Gießform ermöglicht. Diese Methode und Vorrichtung haben den Nachteil, daß die Keimkristalloberfläche während der gesamten Reinigungs- und Aufheizzeit der Gießform einer aggressiven Atmosphäre durch das Ausdampfen von flüchtigen Bestandteilen aus der Gießform ausgesetzt ist, was die Gefahr von Polywachstum, Versetzungsbildungen und hoher Kristalldefektkonzentration zumindest in der Anfangsphase des Kristallwachstums erhöht. Darüber hinaus mußte festgestellt werden, daß die üblichen defektreichen Keimkristalle nachteilig zu polykristallinem Wachstum neigen. Diese Nachteile führen zu einer niedrigen Reproduzierbarkeit der Einkristallzucht und damit zu hohem Ausschuß.

Aus Sulzer Technical Review 70 (1988) No.3, 5.11-16 ist ein Verfahren und eine Vorrichtung bekannt mit denen einkristalline Triebwerksschaufeln durch Vergießen einer Metallschmelze in eine Gießform mit am Boden der Gießform angeordnetem Keimmaterial hergestellt werden, wobei die Gießform getrennt vom Keimmaterial und zum Schutz des Keims vor Oxidation unter Vakuumbedingungen separat gereinigt wird.

Aus Aviation Week and Space Technology , Bd. 111, Nr. 23 Seiten 41 bis 43 ' geht hervor, daß in bekannten Anlagen der Keimkristall mit einer getrennt ausgeheizten Gießform zunächst vertikal zusammengeführt wird und dann ein Aufschmelzen von Schmelzgut über dieser Gießform zusammen mit dem Keimkristall durch Elektronenstrahlaufschmelzen von Legierungsstäben erfolgt.

Aufgabe der Erfindung ist es, die Reproduzierbarkeit der Einkristallzucht von Triebwerksschaufeln durch die Angabe eines Verfahrens und einer Vorrichtung zu erhöhen, so daß weniger Ausschuß anfällt und preiswerter einkristalline Schaufeln für den Triebwerksbau zur Verfügung gestellt werden können.

Diese Aufgabe wird durch ein Verfahren mit folgenden Verfahrensschritten gelöst
a) Präparation eines defektarmen einkristallinen Keimkristalls aus oberflächig defektreichem einkristallinem Schaufelmaterial, das einen defektarmen Kern aufweist, indem der Keimkristall unmittelbar vor dem Einbau in einen Wärmeleitungsblock von oberflächigen, defektreichen Bereichen und Schichten befreit wird,
b) Ausheizen der Gießform und Aufschmelzen eines Schmelzgutes zur Metallschmelze räumlich getrennt vom Keimkristall,
c) unmittelbar nachfolgendes Zusammenführen von Keimkristall, ausgeheizter Gießform und Metallschmelze, wobei sich Gießform und Metallschmelze auf Abgußtemperatur befinden.

Dieses Verfahren hat den Vorteil, daß durch die Präparation eines defektarmen einkristallinen Keimkristalls und das unmittelbar nachfolgende Zusammenführen von Keinkristall, ausgeheizter Gießform und Metallschmelze ein ungestörtes epitaktisches Anwachsen der Schmelze an dem Keimkristall gewährleistet ist, da der Keimkristall nur wenige Sekunden ohne Schmelzbedeckung der ausgeheizten Gießform ausgesetzt ist und damit eine Kontamination der Keimkristalloberfläche durch Verunreinigungen und eine Oxydation sowie Korrosion vermieden werden.

Eine bevorzugte Durchführung des Verfahrens sieht vor, daß der einkristalline Keimkristall in einem konturnah angepaßten Wärmeleitungsblock gehalten wird, so daß die Kristallisationswärme über den Wärmeleitungsblock abgeführt werden kann. In der Abgußphase der Metallschmelze wird durch die konturnahe Anpassug des Wärmeleitungsblocks vorteilhaft erreicht, daß der Keimkristall nicht zerstört wird. Keimkristall und Wärmeleitungsblock werden vorzugweise so vorbereitet, daß sie schnell und unter Reinstraumbedingungen in einer kühlbaren Halterung einer Vorrichtung zur Einkristallzucht fixiert werden können.

Beim Zusägen und Polieren des Keimkristallmaterials werden Spannungen und Kristalldefekte im oberflächennahen Bereich induziert. Eine weitere bevorzugte Verfahrensweise besteht darin, daß unmittelbar vor dem Einbau des Keimkristalls in den Wärmeleitungsblock der Keimkristall von oberflächigen, bearbeitungsbedingten, spannungs- und defektreichen Bereichen und Schichten befreit wird. Dieses kann mittels Plasmaätzen, Sputterätzen, elektrochemischem Erodieren oder chemisches Ätzen der gestörten Bereiche erreicht werden, so daß die Defektkonzentration des Keimkristalls auf höchstens 3 visuell erkennbare Defekten pro cm² und mit einer Defektfläche bis 0,1 mm² vermindert wird. Eine derart niedrige Defektkonzentration des verbleibenden Keimkristalls hat sich als nicht störend für ein einkristallines Kristallwachstum erwiesen.

Eine weitere bevorzugte Durchführung des Verfahrens verwendet eine nach unten offene Gießform mit den Abmessungen der Triebwerksschaufel deren untere Öffnung zur Aufnahme des Keimkristalls als Boden angepaßt ist, wobei sich der Gießformquerschnitt im Bodenbereich vom Keimkristallquerschnitt zum Schaufelquerschnitt stetig erweitert. Dadurch wird vorteilhaft ein durchgehend einkristallines Wachstum gefördert und stufenförmige oder abrupte Querschnittsübergänge, die polykristallines Wachstum induzieren könnten, vermieden.

Die Gießform wird vor einem Abguß der Metallschmelze auf eine Abgußtemperatur aufgeheizt und ist in dieser Phase eine erhebliche Verunreinigungsquelle für den Keimkristall. In einer weiteren bevorzugten Durchführung des Verfahrens wird die Gießform in räumlicher Trennung vom Keimkristall in einem Ausheizprozeß hochtemperaturvakuumgereinigt und auf Abgußtemperatur aufgeheizt. Das hat den Vorteil, daß eine heiße hochreine Gießform für ein Zusammenführen von Keimkristall, Gießform und Metallschmelze zur Verfügung steht. Eine extreme Reinhaltung der einkristallinen Oberfläche des Keimkristalls ist mit diesem Hochtemperaturvakuumreinigungsverfahren der Gießform gelungen, so daß die Reproduzierbarkeit der Einkristallzucht von Triebwerksschaufeln vorteilhaft verbessert wurde.

Eine Vorrichtung zur Durchführung der Einkristallzucht von Triebwerksschaufeln ist in Anspruch 4 definiert und weist räumlich getrennte Stationen auf, von denen eine erste Station einen Tiegel, eine Aufheizvorrichtung zur Erschmelzung des Schmelzgutes und eine Vorrichtung zum Abguß der Schmelze aufweist, eine zweite Station mit einer Aufnahme für die Gießform und einer Ausheizvorrichtung zur separaten Hochtemperaturvakuumreinigung und Aufheizung der Gießform bestückt und eine dritte Station mit einem Wärmeleitungsblock, und einer kühlbaren Halterung mit hochtemperaturfesten Koppelelementen zur schmelzdichten Verbindung von Gießform und Wärmeleitungsblock ausgerüstet ist.

Die getrennt angeordneten Stationen haben den Vorteil, daß sie zeitlich und räumlich getrennt zur Durchführung des Verfahrens vorbereitet werden können, so daß eine gegenseitige Kontamination in der Präparationsphase ausgeschlossen wird. Ferner können sie je nach Reinheitsanforderung unterschiedlich ausgerüstet werden. Die oben angegebene Ausstattung ist eine vorteilhafte Mindestausstattung jeder Station, wobei die Hochtemperaturvakuumreinigung der Gießform mittels Vakuum- und Aufheizeinrichtung eine zentrale Bedeutung für die Steigerung der Reproduzierbarkeit der Einkristallzucht von Triebwerksschaufeln hat.

Da auch beim Erschmelzen des Schmelzgutes erhebliche Abdampfungen von Verunreinigungen auftreten können. Beispielsweise aus Hitzeschilden, dem Tiegel oder den Schmelzgutoberflächenschichten ist es vorteilhaft, diesen Bereich in Form einer ersten Station von den übrigen Stationen während der Aufschmelzphase räumlich zu trennen, mit dem Ziel erst im abgußfähigen bzw. hochtemperaturvakuumgereinigten und vorgeheizten Zustand die Stationen eins und zwei mit der dritten Station, die die gefährdete hochreine und defektarme Oberfläche des Keimkristalls hält, zu koppeln.

Durch den Wärmeleitungsblock, der den Keimkristall mittels einer Aussparung umschließt wird die Kristallisationswärme zu der kühlbaren Halterung für den Wärmeleitungsblock während des Kristallwachstums abgeführt. Die Kühlung der Halterung wird nur aktiviert, wenn die Temperaturführung es erfordert.

Beim Einbau des Keimkristalls in den Wärmeleitungsblock soll der Keimkristall aus dem Wärmeleitungsblock herausragen, vorzugsweise um eine Höhe, die mindestens der Querschnittsbreite des Keimkristalls entspricht. Dieser Einbau hat den Vorteil, daß beim Abguß einer überhitzten Schmelze das defekt- und spannungsarme Kernmaterial des Keimkristalls bis zu der aus dem Wärmeleitungsblock herausragenden Höhe angeschmolzen werden kann, bevor das einkristalline epitaktische Wachstum einsetzt. Die Zuverlässigkeit und Reproduzierbarkeit des Verfahrens wird damit weiter erhöht.

Zum kurzzeitigen schmelzdichten Ankoppeln des Keimkristalls an die heiße Gießform sind mehrere Anordnungen geeignet.

Eine bevorzugte Anordnung weist einen äußeren Flansch im Bodenbereich der Gießform auf, der formschlüssig mit einem Flansch am Wärmeleitungsblock korrespondiert, so daß vorteilhaft ein stufenloser Übergang zwischen dem Keimkristall und dem zu bildenden Schaufelfuß erreicht wird, da ein paßgenaues Aufsetzen der nach unten offenen Gießform auf den Keimkristallquerschnitt durch die korrespondierenden Flansche gesichert wird.

Bei einer weiteren bevorzugten Anordnung bilden die Flansche von Gießform und Wärmeleitungsblock einen Bajonettverschluß mit inneren konischen Dichtflächen, so daß vorteilhaft nach dem Aufsetzen der Gießform auf das Kernmaterial die inneren konischen Dichtflächen ein schmelzdichtes Aufsetzen sichern und der Formschluß zwischen Gießform und Wärmeleitungsblock bei hohen Temperaturen mit einer schnellen Drehbewegung an einem Bajonettring des Bajonettverschlusses hergestellt werden kann.

Die korrespondierenden Flansche weisen bevorzugt ineinander passende Ringnuten auf, die ein zentrisches Aufsetzen der Gießform auf die Halterung sichern und den Formschluß von Gießform und Wärmeleitungsblock herstellen.

Ferner kann ein Schnellverschluß in einer bevorzugten Ausbildung der Erfindung mit mindestens zwei außen ansetzbaren Klammern ausgerüstet sein, die Wärmeleitungsblock und Gießform nach dem Aufsetzen der Gießform schnell und formschlüssig im Heißzustand verbinden und sichern.

Aufgrund unterschiedlicher Verfahrvorrichtungen zum Zusammenführen der Stationen kann die erfindungsgemäße Vorrichtung verschiedene räumliche Anordnungen aufweisen.

Bei einer bevorzugten Ausbildung der Vorrichtung wird die heiße Gießform zunächst zur dritten Station verfahren. Bei dem anschließenden gemeinsamen Transport von Gießform und Halterung aus der dritten Station zur ersten Station wird vorteilhaft ein kurzzeitiges Zusammenfügen der drei Einheiten aus Gießform, Halterung und Abgußstation erreicht. In dieser bevorzugten Ausbildung wird die Abgußstation mit der heißen Schmelze nicht verfahren, wodurch die Temperatur der Schmelze bis zum Abguß sehr genau eingesellt werden kann.

In einer weiteren Ausbildung der Vorrichtung sind Verfahrvorrichtungen für die heiße Gießform aus der zweiten Station und für den Tiegel mit Schmelze aus der ersten Station zur dritten Station vorgesehen. Das hat den Vorteil, daß die Halterung mit dem Keimkristall und dem Wärmeleitungsblock nicht verfahren wird, so daß die Temperatur des Keimkristalls während des gesamten Prozesses genau einstellbar bleibt.

In einer weiteren bevorzugten Ausbildung der Erfindung sind die Stationen in einem Behälter vertikal übereinander angeordnet. Der Behälter ist mittels Schiebern zwischen den Stationen in räumlich getrennte, evakuierbare und/oder mit Gas spülbare Räume aufgeteilt. Die erste Station mit einer Kippvorrichtung für den Tiegel befindet sich im oberen Bereich des Behälters. Am Boden des Behälters ist eine Hubvorrichtung als Verfahrvorrichtung angeordnet.

Nach den unterschiedlichen Vorbereitungen der drei Stationen in den drei evakuierbaren Räumen zum Abguß und einem Öffnen der Schieber kann die Hubvorrichtung durch eine Hubbewegung die drei Einheiten zum Abguß vorteilhaft in kürzester Zeit zusammenfahren.

Weiterhin ist vorgesehen, daß mit der Vorrichtung vorzugsweise mehrere einkristalline Schaufeln gleichzeitig herstellbar sind. In diesem Fall verfügt die Vorrichtung über mehrere einzelne den Schaufeln zugeordnete Wärmeleitungsblocks mit Keimkristallen, die von einer gemeinsamen Halterung gekühlt und falls erforderlich verfahren werden können. Außerdem weist dann die zweite Station mehrere Gießformen auf, die beispielsweise von einem gemeinsamen Flansch mit der Halterung der Wärmeleitungsblocks vor dem Abguß der Schmelze verbunden werden.

Mit den folgenden Figuren wird eine bevorzugte Durchführung des erfindungsgemäßen Verfahrens und eine bevorzugte Ausbildung der Vorrichtung dargestellt.
- Fig. 1: zeigt eine Gießform für eine Turbinenschaufel mit Keimkristall in Abgußposition
- Fig. 2: zeigt eine Vorrichtung zur Herstellung einer einkristallinen Turbinenschaufel.

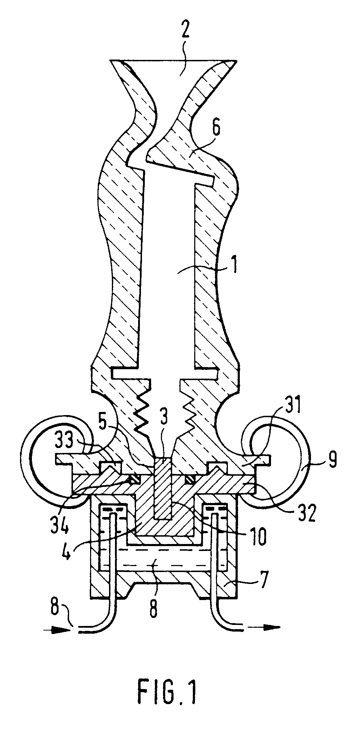

Fig. 1 zeigt eine Gießform 6 für eine Turbinenschaufel 1 mit Keimkristall 3 in Abgußposition.

Im ersten Arbeitsgang des Verfahrens wird ein Keimkristall 3 aus einkristallinem Vollmaterial nach bekanntem Verfahren zunächst als kristalldefektreicher Keimkristallrohling hergestellt. Der Keimkristallrohling kann vor einem endgültigen Abtrag oberflächennaher spannungs- und defektreicher Schichten als Werkzeug zum elektroerosiven Ätzen einer Aussparung 10 aus einem Wärmeleitungsblock 4, die dem Keimkristallquerschnitt angepaßt ist, eingesetzt werden.

Danach folgt die Präparation des Keimkristalls aus dem oberflächig spannungs- und defektreichen, einkristallinen Keimkristallrohling, der üblicherweise zusätzlich von Oxidschichten bedeckt ist. Dazu wird der Keimkristallrohling oberflächig bis auf ein spannungs- und defektarmes einkristallines Kernmaterial mit einer Defektdichte von höchstens 3 visuell erkennbaren Defekten pro cm² und mit einer Defektfläche bis 0,1 mm² abgetragen. Der Keimkristall 3 wird anschließend in die Aussparung 10 des Wärmeleitungsblockes 4 eingesetzt. Danach wird der Wärmeleitungsblock in die Halterung 7, die eine Kühlung 8 aufweist, gesteckt.

Die Gießform 6, die aus einem wärmeisolierenden Material besteht und nach dem bekannten Wachsausschmelzverfahren einem Schaufelmodell nachgebildet wurde, hat am Boden eine Öffnung 5, die dem Querschnitt des Keimkristalls 3 entspricht. Die Gießform 6 weist nach oben einen Angußtrichter 2 auf und erweitert sich im Bodenbereich zu einem Flansch 31, der mit einem Flansch 32 des Wärmeleitungsblockes 4 korrespondiert. Beide Flansche 31 und 32 werden kurz vor dem Abguß in heißem Zustand zusammengefahren und können mit Klammern 9 fixiert werden. Eine Ringnut 33 ist im Flansch 31 eingearbeitet, um ein präzises Aufsetzen der Gießform 6 auf den Wärmeleitungsblock 4 zu sichern. Eine zusätzliche Ringnut 34 im Flansch 32 des Wärmeleitungsblockes ist im Dichtmaterial gefüllt, um die Gießform 6 schmelzdicht über dem Keimkristall 3 abzuschließen.

Nach einem Hochtemperaturvakuumreinigen und Aufheizen der Gießform 6 in räumlicher Trennung vom Keimkristall 3 und dem kurzzeitigen Ankoppeln des Wärmeleitungsblocks 4 mit dem Keimkristall 3 an die Gießform 6 kann das zwischenzeitlich und örtlich getrennt erschmolzene Schmelzgut über den trichterförmigen Anguß 2 der Gießform 6 auf den Keimkristall 3 gegossen werden.

Entscheidend für den Erfolg des Verfahrens ist, daß die hochreine Oberfläche des Keimkristalls 3 bis zum Abguß der Schmelze nicht verunreinigt wird. Beim Einsatz einer überhitzten Schmelze wird der Keimkristalls 3 angeschmolzen, bis die Kühlung 8 der Halterung 7 über den Wärmeleitungsblock 4 soviel Wärme abführt, daß ein einkristallines epitaktisches Wachstum an der angeschmolzenen Keimkristalloberfläche einsetzt und sich mit zunehmender Kristallisationsgeschwindigkeit eine einkristalline Schaufel bildet.

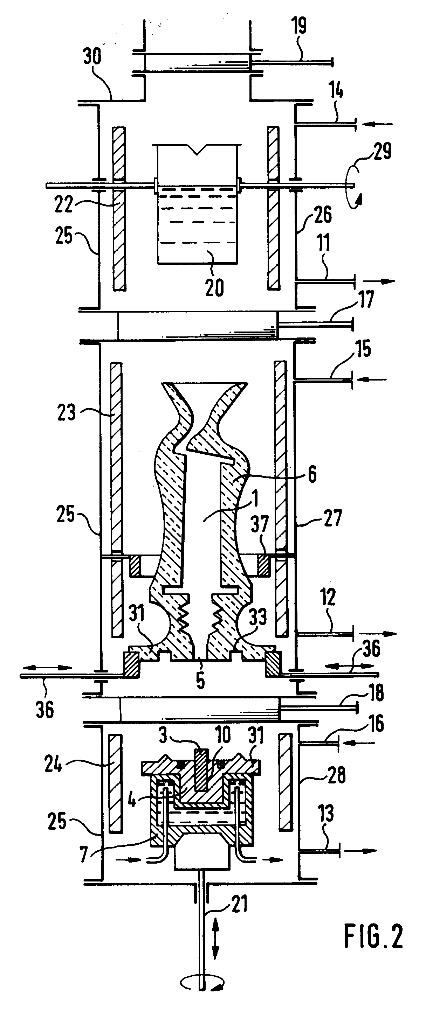

Fig. 2 zeigt eine Vorrichtung zur Herstellung einer einkristallinen Turbinenschaufel 1, die drei örtlich getrennte Stationen 26, 27 und 28 aufweist. Davon ist die erste Station 26 mit einem Tiegel 20 und einer Aufheizvorrichtung 22 zur Erschmelzung des Schmelzgutes und einer Kippvorrichtung 29 zum Abguß der Schmelze ausgerüstet. Eine zweite Station 27 ist mit einer Aufnahme 36 für eine nach unten offene Gießform 6 mit einer dem Keimkristallquerschnitt angepaßten Öffnungen 5 und einer Ausheizvorrichtung 23 zur separaten Hochtemperaturvakuumreinigung und Aufheizung der Gießform 6 bestückt. Eine dritte Station 28 besitzt mindestens einen Wärmeleitungsblock 4, der eine dem Keimkristallquerschnitt angepaßte Aussparung 10 für die Aufnahme des Keimkristalls 3 aufweist, und eine kühlbare Halterung 7 mit hochtemperaturfesten Koppelelementen zur schmelzdichten Verbindung von Gießform 6 und Wärmeleitungsblock 4.

Die drei Stationen 26, 27 und 28 sind in Fig. 2 in einem Behälter 25 übereinander angeordnet und durch zwei Vakuumschieber 17 und 18 getrennt. Ein dritter Vakuumschieber 19 im Deckel 30 des Behälters 25 ermöglicht das Einbringen des Schmelzgutes in den Tiegel 20. Die Vakuumschieber 17 und 18 sind beim Erschmelzen des Schmelzgutes im Tiegel 20 und bei der Hochtemperaturvakuumreinigung und beim Aufheizen der Gießform 6 und einem Vorwärmen des Keimkristalles 3 geschlossen. Nach Beendigung dieser Präparationsphasen in den räumlich getrennten Stationen 26, 27 und 28 werden die Schieber 17 und 18 geöffnet, sobald durch Einleiten von Inertgas über die Zuleitungen 14, 15 und 16 oder durch Angleichen der Vakui mittels der Vakuumleitungen 11, 12 und 13 ein Druckausgleich hergestellt ist.

Mittels der Hubvorrichtung 21 kann anschließend in wenigen Sekunden der Wärmeleitungsblock 4 mit der Gießform 6 verbunden und beide in den Abgußbereich des Tiegels 20 gehoben werden. In der Abgußposition sorgt ein Arretierring 37, der den Flansch 31 beim Hochfahren arretiert für einen ausreichenden Gegendruck, um die Flansche 31 und 32 schmelzdicht bei hoher Temperatur aufeinanderzupressen. Nach dem Abguß und dem Beginn eines epitaxialen Wachstums kann in einer mittleren oder tiefen Positio oder in einer nicht abgebildeten weiteren Station eine vollständige einkristalline Erstarrung der Schmelze erfolgen.

Nach dieser vollständigen Erstarrung und dem Ausbau der Gießform 6 aus der Vorrichtung wird die Gießform 6 mit bekannten Mitteln von der einkristallinen Schaufel getrennt. Durch entsprechende Trennfugen in der Gießform 6 kann eine mehrfache Nutzung der Gießform erreicht werden.

## Patentansprüche

1. Verfahren zur Herstellung von einkristallinen Triebwerksschaufeln durch Vergießen einer Metallschmelze in eine Gießform mit am Boden der Gießform angeordnetem Keimkristall, wobei die Gießform räumlich vom Keimkristall getrennt aufgeheizt wurde, gekennzeichnet durch folgende Verfahrensschritte
a) Präparation eines defektarmen einkristallinen Keimkristalls (3) aus oberflächig defektreichem einkristallinem Schaufelmaterial, das einen defektarmen Kern aufweist, indem der Keimkristall unmittelbar vor dem Einbau in einen Wärmeleitungsblock (4) von oberflächigen, defektreichen Bereichen und Schichten befreit wird,
b) Ausheizen der Gießform (6) und Aufschmelzen eines Schmelzgutes zur Metallschmelze räumlich getrennt vom Keimkristall (3),
c) unmittelbar nachfolgendes Zusammenführen von Keimkristall (3), ausgeheizter Gießform (6) und Metallschmelze, wobei sich Gießform und Metallschmelze auf Abgußtemperatur befinden.

2. Verfahren nach Anspruch 1, dadurch gekennzeichnet, daß der einkristalline Keimkristall (3) in einem konturnah angepaßten Wärmeleitungsblock (4) gehalten wird.

3. Verfahren nach Anspruch 1 oder 2, dadurch gekennzeichnet, daß die Gießform (6) in räumlicher Trennung vom Keimkristall (3) und vom Schmelzgut beim Ausheizen hochtemperaturvakuumgereinigt und auf Abgußtemperatur aufgeheizt wird.

4. Vorrichtung zur Durchführung des Verfahrens nach einem der Ansprüche 1 bis 3, gekennzeichnet durch räumlich getrennte und getrennt betreibbare Stationen (26, 27 und 28), von denen eine erste Station (26) einen Tiegel (20), eine Aufheizvorrichtung (22) zur Erschmelzung des Schmelzgutes und eine Vorrichtung zum Abguß der Schmelze aufweist, eine zweite Station (27) mit einer Aufnahme (36) für die Gießform (6) und einer Ausheizvorrichtung (23) zur separaten Hochtemperaturvakuumreinigung und Aufheizung der Gießform (6) bestückt und eine dritte Station (28) mit einem Wärmeleitungsblock (4), und einer kühlbaren Halterung (7) mit hochtemperaturfesten Koppelelementen zur schmelzdichten Verbindung von Gießform (6) und Wärmeleitungsblock (4) ausgerüstet ist, und der einkristalline Keimkristall (3) aus dem Wärmeleitungsblock (4) herausragt, um eine Höhe, die mindestens der Querschnittsbreite des Keimkristalls (3) entspricht.

5. Vorrichtung nach Anspruch 4, dadurch gekennzeichnet, daß die Gießform (6) einen äußeren Flansch (31) im Bodenbereich aufweist, der formschlüssig mit einem Flansch (32) an dem Wärmeleitungsblock (4) korrespondiert.

6. Vorrichtung nach einem der Ansprüche 4 bis 5, dadurch gekennzeichnet, daß der Formschluß zwischen Wärmeleitungsblock (4) und Gießform (6) als Bajonettverschluß mit inneren konischen Dichtflächen ausgebildet ist.

7. Vorrichtung nach einem der Ansprüche 4 bis 5, dadurch gekennzeichnet, daß der Formschluß von Gießform (6) und Wärmeleitungsblock (4) durch ineinander passende Ringnuten gebildet wird.

8. Vorrichtung nach einem der Ansprüche 4 bis 5, dadurch gekennzeichnet, daß der Formschluß von Gießform (6) und Wärmeleitungsblock (4) durch zwei von außen im Heißzustand ansetzbare Klammern (9) zum Verbinden von Gießform (6) und Wärmeleitungsblock (4) gesichert ist.

9. Vorrichtung nach einem der Ansprüche 4 bis 8, dadurch gekennzeichnet, daß Verfahrvorrichtungen zum schnellen Zusammenführen für die heiße Gießform (6), den Wärmeleitungsblock (4) mit Keimkristall (3) und den Tiegel (20) mit Metallschmelze vorhanden sind.

10. Vorrichtung nach einem der Ansprüche 4 bis 9, dadurch gekennzeichnet, daß die Stationen (26,27 und 28) in einem Behälter (25) vertikal übereinander angeordnet sind und der Behälter (25) Schieber (17 und 18) zwischen den Stationen (26,27 und 28) zur Trennung in evakuierbare und/oder mit Gas spülbare Räume aufweist, wobei die erste Station (26) mit einer Kippvorrichtung für den Tiegel (20) oben und am Boden des Behälters (25) als Verfahrvorrichtung eine Hubvorrichtung (21) angeordnet ist.

## Claims

1. A method for producing single-crystal engine blades by pouring a metal melt into a casting mould with a seed crystal positioned at the bottom of the casting mould, wherein the casting mould has been heated spatially separately from the seed crystal, characterized by the following method steps:
a) preparing a low-defect, single-crystal seed crystal (3) of high surface-defect, single-crystal blade material which has a low-defect nucleus, by ridding the seed crystal of high surface-defect areas and layers immediately before mounting it in a heat conduction block (4),
b) baking the casting mould (6) and melting a melting charge to form the metal melt spatially separately from the seed crystal (3),
c) bringing together immediately thereafter the seed crystal (3), the baked casting mould (6) and the metal melt, the casting mould and the metal melt being at pouring temperature.

2. A method according to claim 1, characterized in that the single-crystal seed crystal (3) is held in a closely contour-matched heat conduction block (4).

3. A method according to claim 1 or 2, characterized in that the casting mould (6) is high-temperature vacuum-cleaned and heated up to pouring temperature during baking spatially separate from the seed crystal (3) and the melting charge.

4. Apparatus for carrying out the method according to one of claims 1 to 3, characterized by spatially separate and separately operable stations (26, 27 and 28), of which a first station (26) has a crucible (20), a heating device (22) for melting the melting charge and a device for pouring the melt, a second station (27) is equipped with a holder (36) for the casting mould (6) and a baking device (23) for separate high-temperature vacuum-cleaning and heating of the casting mould (6), and a third station (28) is provided with a heat conduction block (4) and a coolable mount (7) with high temperature-resistant coupling elements for the melt-proof joining together of the casting mould (6) and the heat conduction block (4), and the single-crystal seed crystal (3) projects from the heat conduction block (4) by a height which corresponds at least to the cross-sectional width of the seed crystal (3).

5. Apparatus according to claim 4, characterized in that the casting mould (6) has an external flange (31) in the base region which corresponds in a positively engaging manner with a flange (32) on the heat conduction block (4).

6. Apparatus according to one of claims 4 to 5, characterized in that the positive engagement between the heat conduction block (4) and the casting mould (6) is designed as a bayonet closure with internal conical sealing surfaces.

7. Apparatus according to one of claims 4 to 5, characterized in that the positive engagement of the casting mould (6) and the heat conduction block (4) is formed by annular grooves which fit into one another.

8. Apparatus according to one of claims 4 to 5, characterized in that the positive engagement of the casting mould (6) and the heat conduction block (4) is secured by two clips (9), attachable from the exterior in the hot state, for joining the casting mould (6) and the heat conduction block (4) together.

9. Apparatus according to one of claims 4 to 8, characterized in that moving devices for the hot casting mould (6), the heat conduction block (4) with the seed crystal (3) and the crucible (20) with the metal melt are provided for bringing them together quickly.

10. Apparatus according to one of claims 4 to 9, characterized in that the stations (26, 27 and 28) are arranged vertically one above another in a container (25) and the container (25) has slide valves (17 and 18) between the stations (26, 27 and 28) to separate it into compartments which may be evacuated and/or flushed with gas, the first station (26) with a tilting device for the crucible (20) being arranged at the top of the container (25) and a lifting device (21) as the moving device being arranged at the bottom.

## Revendications

1. Procédé de fabrication d'aubes de moteur monocristallins en coulant un bain de fusion dans un moule de coulée avec un germe cristallin disposé au fond du moule, le moule de coulée étant chauffé localement de façon séparée par rapport au germe cristallin,
caractérisé par les étapes suivantes :
a) préparation d'un germe monocristallin contenant peu de défauts (3) en une matière pour aube monocristalline contenant superficiellement beaucoup de défauts, matière qui présente un noyau contenant peu de défauts, en libérant le germe cristallin directement avant l'insertion dans un bloc de conduction thermique (4) de zones et de couches superficielles, contenant beaucoup de défauts.
b) chauffage du moule de coulée (6) et fusion d'un bain de fusion servant à fondre le métal de façon physiquement séparée du germe cristallin (3).
c) réunion tout de suite après, du germe cristallin (3), du moule de coulée chauffé (6) et du bain de fusion, le moule de coulée et le bain métallique de fusion se trouvant à la température de la coulée.

2. Procédé selon la revendication 1,
caractérisé en ce que,
le germe monocristallin (3) est maintenu dans un bloc de conduction thermique adapté (4) au contour proche.

3. Procédé selon la revendication 1 ou 2,
caractérisé en ce que
le moule de coulée (6) est purifié sous vide à haute température et est chauffé dans le cadre d'une séparation physique du germe cristallin (3) et du produit de fusion lors du chauffage à la température de coulée.

4. Dispositif pour la mise en oeuvre du procédé selon l'une des revendications 1 à 3,
caractérisé par
des postes (26, 27 et 28) physiquement séparés et pouvant être utilisés séparément, parmi lesquels un premier poste (26) est équipé d'un creuset (20), d'un dispositif de chauffage (22) servant à l'élaboration du produit de coulée et d'un dispositif servant à couler le bain de fusion, un second poste (27) est équipé d'un logement (36) servant à recevoir le moule (6) et d'un dispositif de chauffage (23) servant à purifier sous vide à haute température et à chauffer le moule de coulée (6) et un troisième poste (28) est équipé d'un bloc de conduction thermique (4) et d'un support (7), qui peut être refroidi, avec des éléments d'accouplement résistant aux hautes températures servant à relier, d'une façon étanche par rapport au bain de fusion le moule de coulée (6) et le bloc de conduction thermique (4) et dans lequel dispositif le germe monocristallin (3) fait saillie hors du bloc de conduction thermique (4) sur une hauteur, qui correspond au moins à la largeur de la section transversale du germe cristallin (3).

5. Dispositif selon la revendication 4,
caractérisé en ce que
le moule (6) présente une bride extérieure (31) dans la zone du fond, qui correspond par une liaison par la forme à une bride (32) sur le bloc de conduction thermique (4).

6. Dispositif selon l'une des revendications 4 à 5,
caractérisé en ce que,
la liaison par la forme entre le bloc de conduction thermique (4) et le moule (6) est constitué sous la forme d'une fermeture à baïonnette avec des surfaces d'étanchéité intérieures coniques.

7. Dispositif selon l'une des revendications 4 à 5,
caractérisé en ce que
la liaison par la forme du moule (6) et du bloc de conduction thermique (4) est formé par des rainures annulaires adaptées l'une à l'autre.

8. Dispositif selon l'une des revendications 4 à 5,
caractérisé en ce que
la liaison par la forme du moule (6) et du bloc de conduction de la chaleur (4) est assuré par deux brides de jonction (9) pouvant être montés à chaud de l'extérieur servant à relier le moule (6) et le bloc de conduction de la chaleur (4).

9. Dispositif selon l'une des revendications 4 à 8,
caractérisé en ce qu'
il y a des dispositifs de déplacement servant à une réunion rapide du moule de coulée brûlant (6) du bloc de conduction de la chaleur (4) avec le germe cristallin (3) et du creuset (20) avec le bain métallique de fusion.

10. Dispositif selon l'une des revendications 4 à 9,
caractérisé en ce que
les postes (26, 27 et 28) sont disposés verticalement les uns au-dessus des autres dans un récipient (25), le récipient (25) présente des tiroirs (17 et 18) entre les postes 26, 27 et 28) servant à les séparer en chambres que l'on peut évacuer et/ou rincer au gaz, le premier poste (26) étant disposé avec un dispositif de basculement pour le creuset (20) en haut et un dispositif de levage étant disposé sur le fond du récipient (25) en tant que dispositif de déplacement.
